# FASCICULE DE BREVET EUROPEEN

(11) **EP 3 499 584 B1**
(45) Date de publication et mention de la délivrance du brevet: **25.11.2020**
(21) Numéro de dépôt: 18206252.1
(22) Date de dépôt: 14.11.2018
(51) Int. Cl.: H01L 31/042, H01L 31/02, H02S 40/36, H02S 40/34

(54) **INFRASTRUCTURE FONCTIONNALISÉE ET PROCÉDÉ D'INSTALLATION D'UNE TELLE INFRASTRUCTURE FONCTIONNALISÉE**
FUNKTIONALISIERTE INFRASTRUKTUR UND VERFAHREN ZUM AUFBAU EINER SOLCHEN FUNKTIONALISIERTEN INFRASTRUKTUR
FUNCTIONALIZED INFRASTRUCTURE AND METHOD OF INSTALLING SUCH A FUNCTIONALIZED INFRASTRUCTURE

(30) Priorité: 13.12.2017 FR 1762050
(43) Date de publication de la demande: 19.06.2019
(73) Titulaire: Commissariat à l'Énergie Atomique et aux Énergies Alternatives, 75015 Paris (FR); COLAS, 75015 Paris (FR)
(72) Inventeur: CHAINTREUIL, Nicolas, 73800 MONTMELIAN (FR); BARRUEL, Franck, 73370 LE BOURGET DU LAC (FR)
(74) Mandataire: Jacobacci Coralis Harle

(56) Documents cités:
- US-A1- 2005 199 282
- GNATOV ANDREY ET AL: "Smart road as a complex system of electric power generation", 2017 IEEE FIRST UKRAINE CONFERENCE ON ELECTRICAL AND COMPUTER ENGINEERING (UKRCON), IEEE, 29 mai 2017 (2017-05-29), pages 457-461, XP033251258, DOI: 10.1109/UKRCON.2017.8100531

## Description

### Domaine technique de l'invention

La présente invention se rapporte à une infrastructure fonctionnalisée et à un procédé d'installation d'une telle infrastructure fonctionnalisée.

Par le terme "infrastructure", de manière non limitative, on entend une chaussée de type route ou autoroute, mais aussi un mur ou un toit.

Par le terme "fonctionnalisée", de manière non limitative, on entend l'apport d'une fonction de type générateur d'énergie électrique par l'utilisation de cellules photovoltaïques, ou de type récepteur d'énergie électrique.

Il s'agira donc d'apporter, grâce à l'infrastructure, une ou plusieurs fonctions telles que génération d'énergie électrique par l'utilisation de cellules photovoltaïques, signalisation visuelle ou sonore, éclairage, mais aussi comptage de véhicule ou rechargement des batteries d'un véhicule électrique.

### Etat de la technique

Pour rentabiliser l'espace, notamment dans les agglomérations, il a été proposé de réaliser des routes qui intègrent des cellules photovoltaïques. Comme les routes sont souvent bien exposées au soleil, elles sont à même de pouvoir capter facilement l'énergie lumineuse. En leur intégrant des cellules photovoltaïques, elles peuvent convertir l'énergie lumineuse captée en énergie électrique. L'énergie électrique produite par les routes peut alors être employée de diverses manières. Des convertisseurs sont par exemple judicieusement positionnés au bord des routes pour renvoyer l'énergie électrique générée vers le réseau ou toute autre installation.

Les documents référencés FR3016257A1 et US8080901B2 décrivent de telles solutions de route fonctionnalisée à partir de cellules photovoltaïques ou de convertisseurs d'énergie de type piézoélectrique ou thermoélectrique.

Les documents WO2016/16165A1 et WO2016/16170A1 décrivent quant à eux une structure multicouches d'un module photovoltaïque, qui peut être employée pour réaliser la couche de roulement d'une chaussée fonctionnalisée. Cette structure multicouches présente notamment des caractéristiques mécaniques suffisantes pour absorber les chocs et subir les différentes sollicitations mécaniques d'une couche de roulement d'une chaussée.

Le document US 2005/199282 A1 décrit une infrastructure fonctionnalisée comportant des dalles de revêtement agencées de manière juxtaposée, chaque dalle de revêtement comprenant un ensemble de fonctionnalisation électrique et un bloc de connexion électrique.

Cependant, même si la perspective de fonctionnaliser les routes est particulièrement intéressante, celle-ci se heurte pour le moment à des difficultés de mise en œuvre. Les connectiques électriques ont souvent tendance à s'user par oxydation. De plus, une fois l'infrastructure installée, sa maintenance et son entretien restent compliqués, le moindre dysfonctionnement nécessitant souvent de casser la route pour accéder aux parties défectueuses.

Il n'existe donc pour le moment aucune solution permettant de réaliser une infrastructure fonctionnalisée qui soit fiable, peu couteuse, facile à installer et à entretenir.

Le but de l'invention est de proposer une solution pour réaliser une infrastructure fonctionnalisée de manière simple, peu couteuse, qui soit facile à installer et à entretenir en cas de dysfonctionnement.

### Exposé de l'invention

Ce but est atteint par une infrastructure fonctionnalisée comportant une couche inférieure comprenant une zone à recouvrir, ladite infrastructure comportant :
- n dalles de revêtement, n étant supérieur ou égal 2, les n dalles comportant chacune une surface de couverture pour recouvrir une partie de ladite zone, les n dalles étant agencées de manière juxtaposée afin de paver ladite surface à recouvrir, chaque dalle de revêtement comprenant au moins un ensemble de fonctionnalisation électrique, et en ce que :
   - Les n dalles de revêtement comportent au moins une dalle de revêtement d'un premier type présentant une surface de couverture d'une première forme et une dalle de revêtement d'un deuxième type présentant une surface de couverture d'une deuxième forme, distincte de la première forme,
- Chaque dalle de revêtement comportant un bloc de connexion électrique, de telle sorte que pour deux dalles adjacentes directement connectées entres elles:
   - le bloc de connexion électrique de chaque dalle est agencé sur la dalle de manière à être séparé du bloc de connexion électrique de la dalle adjacente d'un pas constant, quelle que soit la forme de chacune de leur dalle;
   - l'infrastructure comporte un câble électrique de liaison entre lesdites deux dalles adjacentes, ledit câble étant d'une longueur correspondant audit pas constant.

La solution de l'invention permet de proposer une infrastructure dans laquelle les dalles présentent une architecture standard quelle que soit leur forme, leur permettant de s'adapter à la forme de la surface à recouvrir. La position du bloc de connexion électrique sur la dalle est ainsi choisie pour faire en sorte qu'il puisse toujours être séparé du bloc de connexion électrique de la dalle adjacente d'un pas constant.

Selon une particularité, le pas constant est défini par une longueur de câble suivant une direction rectiligne définie entre la dalle de rang i et la dalle de rang i+1.

Selon une réalisation particulière, ledit bloc de connexion électrique est agencé sur chaque dalle de rang i manière à générer un pas constant suivant deux directions perpendiculaires.

Selon une autre réalisation particulière, ladite dalle de premier type présente une surface de couverture de forme carrée.

Selon une autre réalisation particulière, le bloc de connexion électrique est positionné suivant l'un des côtés du carré formé par la surface de couverture.

Selon une autre réalisation particulière, ladite dalle de deuxième type présente une surface de couverture ayant une forme de triangle rectangle isocèle, dont chaque petit côté présente une longueur égale à celle d'un côté du carré formé par la surface de couverture de la dalle de premier type.

Selon une autre réalisation particulière, le bloc de connexion électrique est agencé suivant l'un ou l'autre des deux petits côtés du triangle rectangle isocèle formé par la surface de recouvrement de la dalle de deuxième type.

Selon l'invention, l'infrastructure comporte un câble de liaison agencé pour relier le bloc de connexion électrique de chaque dalle de rang i au bloc de connexion électrique de la dalle de rang i+1, ledit câble étant d'une longueur définissant ledit pas constant.

Selon une autre réalisation particulière, chaque dalle comporte un bloc de transmission d'énergie sans contact connecté sur ledit bloc de connexion électrique.

Selon une autre réalisation particulière, l'infrastructure comporte un système de transmission d'énergie sans contact comprenant une première partie présentant n blocs de transmission d'énergie sans contact et une deuxième partie formée desdites n dalles, chaque bloc de transmission d'énergie sans contact de la première partie étant positionné pour être en couplage inductif avec un bloc de transmission d'énergie sans contact correspondant distinct de la première partie.

Selon une autre réalisation particulière, l'infrastructure comporte au moins un câble de liaison agencé pour relier chaque bloc de transmission d'énergie sans contact de la première partie d'un bloc de transmission d'énergie sans contact adjacent de la première partie, ledit câble de liaison ayant une longueur correspondant audit pas constant.

Selon une autre réalisation particulière, chaque dalle comporte un ensemble de fonctionnalisation électrique de type générateur d'énergie électrique ou de type récepteur d'énergie électrique.

L'invention concerne également un procédé d'installation d'une infrastructure fonctionnalisée comportant une couche inférieure comprenant une zone à recouvrir, ledit procédé consistant à :
- Recouvrir ladite zone avec n dalles de revêtement agencées de manière juxtaposée afin de paver ladite surface à recouvrir, chaque dalle de revêtement comprenant une surface de couverture positionnée pour recouvrir une partie de ladite zone et au moins un ensemble de fonctionnalisation électrique,
- Les n dalles de revêtement comportent au moins une dalle de revêtement d'un premier type présentant une surface de couverture d'une première forme et une dalle de revêtement d'un deuxième type présentant une surface de couverture d'une deuxième forme, distincte de la première forme,
- Chaque dalle de revêtement comportant un bloc de connexion électrique, de telle sorte que pour deux dalles adjacentes directement connectées entres elles:
   - le bloc de connexion électrique de chaque dalle est agencé sur la dalle de manière à être séparé du bloc de connexion électrique de la dalle adjacente d'un pas constant, quelle que soit la forme de chacune de leur dalle, un câble électrique de liaison de longueur correspondant audit pas constant étant agencé pour relier lesdites deux dalles adjacentes.

Selon une réalisation particulière, ladite dalle de revêtement de premier type présente une surface de couverture de forme carrée.

Selon une autre réalisation particulière, ladite dalle de revêtement de deuxième type présente une surface de couverture ayant une forme de triangle rectangle isocèle, dont chaque petit côté présente une longueur égale à celle d'un côté du carré formé par la surface de couverture de la dalle de premier type.

Selon l'invention, le procédé consiste à employer un câble de liaison agencé pour relier le bloc de connexion électrique de chaque dalle de rang i au bloc de connexion électrique de la dalle de rang i+1, ledit câble étant d'une longueur définissant ledit pas constant.

Selon une autre réalisation particulière, le procédé consiste à mettre en œuvre un système de transmission d'énergie sans contact entre une première partie présentant n blocs de transmission d'énergie sans contact et une deuxième partie formée desdites n dalles de revêtement, chaque bloc de transmission d'énergie sans contact de la première partie étant positionné pour être en couplage inductif avec un bloc de transmission d'énergie sans contact correspondant distinct de la première partie et il consiste à employer au moins un câble de liaison agencé pour relier chaque bloc de transmission d'énergie sans contact de la première partie d'un bloc de transmission d'énergie sans contact adjacent de la première partie, ledit câble de liaison ayant une longueur correspondant audit pas constant.

### Brève description des figures

D'autres caractéristiques et avantages vont apparaître dans la description détaillée qui suit faite en regard des dessins annexés listés ci-dessous :
- La figure 1 représente de manière schématique, en perspective, une dalle de revêtement employée dans une infrastructure de l'invention.
- La figure 2 représente, en coupe transversale, les différentes couches d'un ensemble de fonctionnalisation électrique de la dalle de type module photovoltaïque.
- Les figures 3A et 3B représentent, vue en coupe transversale, une dalle employée dans l'infrastructure fonctionnalisée de l'invention, selon deux configurations distinctes.
- Les figures 4A et 4B représentent, respectivement vu en perspective et vu en coupe transversale, un bloc de transmission d'énergie sans contact employé dans un système de transmission d'énergie sans contact.
- Les figures 5A à 5D illustrent les principales étapes de mise en œuvre d'une infrastructure fonctionnalisée conforme à l'invention.
- Les figures 6A et 6B illustrent le principe d'installation de la première partie du système de l'invention.
- Les figures 7A et 7B représentent, vue de dessus et vu en coupe transversale, une infrastructure fonctionnalisée de type route dotée de plusieurs dalles adjacentes.
- La figure 8 représente en vue de dessus, un premier type de dalle pouvant être employé dans l'infrastructure fonctionnalisée de l'invention.
- La figure 9 représente, en vue de dessus, un deuxième type de dalle pouvant être employé dans l'infrastructure fonctionnalisée de l'invention.
- La figure 10 représente de manière schématique et en vue de dessus une infrastructure fonctionnalisée de l'invention et illustre le principe de connexion à pas constant entre les dalles de cette infrastructure fonctionnalisée.
- La figure 11 illustre une variante de réalisation à l'infrastructure fonctionnalisée de la figure 10.

### Description détaillée d'au moins un mode de réalisation

Dans la suite de la description, les termes "supérieur", "inférieur", "haut", "bas" ou autres termes équivalents sont à considérer en tenant compte d'un axe (A) qui sera défini comme perpendiculaire au plan formé par une dalle (axe vertical dans le plan de la feuille sur les figures annexées).

Comme décrit ci-dessus, par infrastructure, on entend par exemple une zone circulable.

Par "zone circulable", on entend, de manière non limitative, toute zone prévue pour la circulation de piétons et/ou de véhicules, telle que par exemple une chaussée de type route ou autoroute, une piste cyclable, un trottoir ou un parking.

On tiendra compte du fait que l'infrastructure 1 à fonctionnaliser comporte une couche inférieure 10, dotée d'une surface 100 à recouvrir d'une couche fonctionnelle qui permet à ladite infrastructure 1 d'être fonctionnalisée.

L'invention vise notamment à réaliser ladite couche fonctionnelle en employant des dalles de revêtement positionnées de manière adaptée, par exemple de manière adjacentes et jointives, pour recouvrir au moins partiellement la surface 100 de la couche inférieure 10 de ladite infrastructure 1.

Dans le cas d'une infrastructure de type zone circulable, la couche inférieure sera par exemple composée d'un enrobé. Bien entendu, cette couche inférieure ne faisant pas partie de l'invention, toute autre structure monocouche ou multicouches pourra être envisagée.

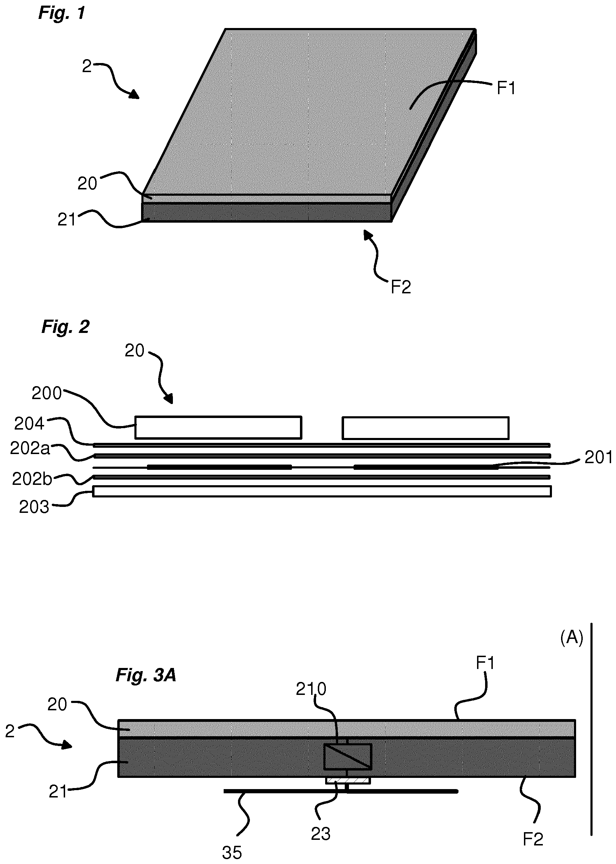

En référence à la figure 1, une dalle de revêtement 2 employée dans l'invention comporte les caractéristiques décrites ci-dessous.

La dalle 2 de l'invention peut se présenter sous la forme d'un élément monobloc, c'est-à-dire ne formant qu'une seule pièce. Elle présente avantageusement une première face, dite face supérieure F1, destinée à former la face externe de l'infrastructure et une face inférieure F2 opposée et préférentiellement parallèle à la face supérieure. Entre ses deux faces, la dalle comporte plusieurs ensembles ou blocs fonctionnels. Ces ensembles et blocs fonctionnels seront logés préférentiellement dans un ou plusieurs boîtiers hermétiques fixés entre eux et présentant, si nécessaire, des moyens de connexion électriques. Sa face supérieure F1 est avantageusement plane. On verra ci-après que cette couche externe, définissant le contour de la dalle, pourra être de différentes formes.

La dalle de revêtement 2 comporte ainsi un ensemble de fonctionnalisation électrique 20 qui permet de conférer à la dalle exclusivement une fonction électrique de type générateur d'énergie électrique ou de type récepteur d'énergie électrique (c'est-à-dire consommateur). L'infrastructure comportant plusieurs dalles de ce type pourra pour sa part être dotée d'une ou plusieurs fonctions, selon le type de dalles employées.

De manière non limitative, cet ensemble de fonctionnalisation électrique 20 de la dalle comporte une première couche 200 présentant une face supérieure, dite également face externe, formant la face supérieure F1 de la dalle 2 évoquée ci-dessus, et destinée à représenter la surface de roulement de la zone circulable.

La dalle de revêtement 2 comporte un bloc électronique 21 connecté à l'ensemble de fonctionnalisation électrique 20 et qui comporte au moins un convertisseur 210.

Selon l'invention, l'ensemble de fonctionnalisation électrique 20 pourra prendre différentes configurations selon la fonctionnalité à apporter à la dalle et à l'infrastructure 1. Il faut noter que le bloc électronique 21 sera préférentiellement toujours identique quelle que soit la configuration de l'ensemble de fonctionnalisation électrique 20.

Dans une première configuration de type récepteur, l'ensemble de fonctionnalisation électrique 20 se présente sous la forme d'un module photovoltaïque. Préférentiellement, il comporte la structure décrite dans les deux demandes de brevet n°WO2016/16165A1 et WO2016/16170A1 et représentée sur la figure 2. Sans rentrer dans les détails, dans cette structure de module photovoltaïque, la première couche 200 décrite ci-dessus est transparente sur toute son épaisseur de manière à laisser passer un flux lumineux.

Par le terme "transparent", on entend que le matériau formant la première couche est au moins partiellement transparent à la lumière visible.

La première couche 200 sera par exemple réalisée sous la forme d'une seule plaque ou de plusieurs plaques juxtaposées. Elle sera par exemple réalisée dans un matériau polymère transparent, tel que par exemple du polyméthacrylate de Méthyle (PMMA).

Par ailleurs, le module photovoltaïque comporte une pluralité de cellules photovoltaïques 201 connectées entre elles en série ou en série/parallèle. De manière connue, celles-ci sont destinées à capter le flux lumineux qui traverse la première couche.

Le module photovoltaïque comporte un ensemble encapsulant dans lequel sont encapsulées les cellules photovoltaïques. Cet ensemble encapsulant est préférentiellement constitué de deux couches 202a, 202b de matériau d'encapsulation, entre lesquelles les cellules photovoltaïques sont encapsulées. Une opération de laminage est mise en œuvre pour fondre les deux couches 202a, 202b d'encapsulation en une seule couche dans laquelle sont noyées les cellules photovoltaïques 201. Le procédé de fabrication est détaillé dans les deux demandes de brevet cités ci-dessus. Celui-ci ne faisant pas partie de l'invention, il n'est pas décrit précisément dans la présente demande.

Par le terme "encapsulant" ou "encapsulé" employé, il faut comprendre que les cellules photovoltaïques 201 sont logées dans un volume, préférentiellement hermétique, formé par l'assemblage des deux couches de l'ensemble.

Le module photovoltaïque comporte une deuxième couche 203, formant la face arrière du module. L'ensemble encapsulant est positionné entre la première couche 200 et cette deuxième couche 203. Cette deuxième couche 203 sera par exemple réalisée dans un matériau de type composite, par exemple de type polymère/fibres de verre.

Le module photovoltaïque comporte avantageusement une couche intermédiaire 204 dite "amortissante" située entre la première couche 200 et la couche supérieure 202a de l'ensemble encapsulant (202a, 202b) et permettant l'assemblage, notamment par collage, de la première couche 200 sur l'ensemble encapsulant.

Le module photovoltaïque comporte avantageusement une couche adhésive (non représentée) située entre l'ensemble encapsulant et la deuxième couche 203. Cette couche servira à l'assemblage, notamment par collage, de la deuxième couche 203 sur l'ensemble encapsulant.

Dans d'autres configurations, l'ensemble de fonctionnalisation électrique pourra comporter exclusivement un circuit récepteur d'énergie électrique.

Dans une deuxième configuration, l'ensemble de fonctionnalisation électrique 20 peut en effet comporter un circuit électronique de signalisation lumineux et/ou sonore.

Le circuit électronique de signalisation lumineux comporte par exemple une ou plusieurs diodes lumineuses permettant de fournir un éclairage.

Dans cette deuxième configuration, la structure de l'ensemble de fonctionnalisation électrique 20 est similaire à celle de la première configuration. Les différences résident dans le fait qu'il emploie un bloc de signalisation incluant des diodes lumineuses.

Dans une troisième configuration, l'ensemble de fonctionnalisation électrique peut comporter un module de recharge de véhicule électrique par induction. Cette solution permet de recharger un véhicule électrique lorsque celui-ci est immobile sur la chaussée ou sur une place de parking.

Dans une quatrième configuration, l'ensemble de fonctionnalisation électrique peut comporter une ou plusieurs prises électriques de manière à y brancher tous types d'appareils électriques.

Dans une cinquième configuration, l'ensemble de fonctionnalisation électrique peut comporter tous types de capteurs, par exemple de type capteur de température ou de type comptage de véhicules.

Dans une sixième configuration, l'ensemble de fonctionnalisation électrique peut comporter une ou plusieurs bornes de connexion à un ou plusieurs réseaux de communication sans fil. Il s'agira par exemple d'une borne fonctionnant selon un protocole de communication connu tel que WIFI, Bluetooth, 3G, 4G ou autre protocole équivalent. Il s'agira alors de proposer une dalle dotée d'une ou plusieurs de ces fonctions de communication.

Dans une septième configuration, l'ensemble de fonctionnalisation électrique peut comporter une structure chauffante comprenant par exemple des résistances ou une résille permettant de chauffer l'infrastructure, pour notamment la dégivrer en hiver.

Pour répondre à l'ensemble des fonctions souhaitées, la dalle de revêtement 2 de l'invention comporte en outre un bloc électronique 21 qui inclut au moins un convertisseur 210 statique bidirectionnel en courant. Grâce à ce convertisseur, selon sa fonction, la dalle 2 pourra agir comme générateur de courant ou comme récepteur de courant.

Pour un ensemble de fonctionnalisation électrique 20 à cellules photovoltaïques, le convertisseur de tension sera de type DC/AC pour convertir le courant continu fourni par les cellules photovoltaïques en courant alternatif.

Pour un ensemble de fonctionnalisation électrique 20 de type récepteur d'énergie électrique le convertisseur sera d'une topologie adaptée au bloc récepteur employé. Par exemple, pour un circuit électronique de signalisation, le convertisseur de tension sera de type AC/DC, le circuit électronique de signalisation étant connecté côté DC.

Pour un ensemble de fonctionnalisation électrique 20 disposant d'un module de recharge électrique par induction d'un véhicule électrique, le convertisseur sera de type AC/AC.

Pour un ensemble de fonctionnalisation électrique 20 à structure chauffante, le convertisseur de tension sera de type AC/AC.

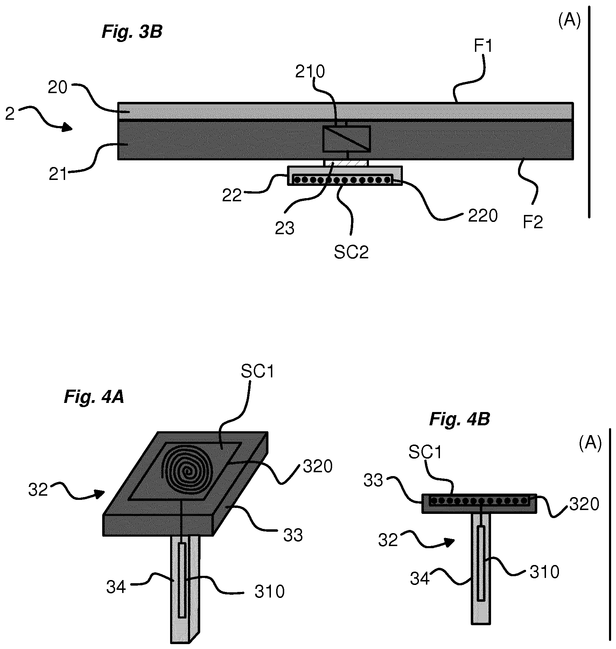

Afin d'exploiter chaque dalle de revêtement telle que décrite ci-dessus, on distingue plusieurs configurations de câblage de l'infrastructure fonctionnalisée :
- Une première configuration consiste à connecter électriquement chaque dalle de revêtement à une autre dalle de revêtement, par des liaisons filaires en série et/ou en parallèle (figure 3A) ;
- Une deuxième configuration consiste à doter chaque dalle 2 d'un bloc 22 de transmission d'énergie sans contact. Pour chaque dalle de revêtement, son bloc de transmission d'énergie sans contact est destiné à être mis en couplage inductif avec un bloc correspondant (figure 3B). Le câblage est alors réalisé entre ces derniers blocs à l'aide d'un câble 35 ;

Ces deux configurations sont expliquées plus en détails ci-dessous.

Dans les deux configurations, chaque dalle comporte avantageusement un bloc de connexion électrique 23 relié au bloc électronique 21.

Dans la première configuration, ce bloc de connexion électrique 23 permet de réaliser l'interconnexion par câble 35 de la dalle avec chaque dalle adjacente.

Dans la deuxième configuration ce bloc de connexion électrique 2 permet de connecter le bloc 2 de transmission d'énergie sans contact.

Dans la première configuration illustrée par la figure 3A, la connexion entre les dalles est réalisée de manière filaire. Cette solution devra tenir compte de l'ensemble de fonctionnalisation de la dalle, en mode générateur ou récepteur. Les dalles sont en effet regroupées par fonction. Celles qui sont à fonction photovoltaïque sont par exemple connectées entre elles uniquement, en série et/ou en parallèle. Bien entendu, plusieurs groupes de dalles pourront être réalisés.

Les dalles seront ensuite incluses dans une architecture électrique globale comportant notamment au moins par exemple un convertisseur électrique central.

Le bloc de connexion électrique 23 pourra être intégré en tout ou partie au bloc électronique 21 décrit ci-dessus.

Dans la deuxième configuration évoquée ci-dessus, la dalle 2 comporte ainsi un bloc de transmission d'énergie sans contact 22 qui comporte un coupleur inductif 220. De manière connue, ce coupleur inductif 220 comporte un enroulement de spires et est destiné à être positionné en vis-à-vis d'un deuxième coupleur inductif pour réaliser un transfert d'énergie électrique sans contact, c'est-à-dire sans fil, par couplage électromagnétique. L'un des deux coupleurs forme ainsi le primaire d'un transformateur et l'autre des deux coupleurs forme le secondaire du transformateur. Selon la nature de l'ensemble de fonctionnalisation électrique de la dalle, le transfert d'énergie entre les deux coupleurs sera réalisé dans un sens ou dans l'autre. Si l'ensemble de fonctionnalisation électrique comporte un générateur de courant (par exemple un module photovoltaïque), le transfert d'énergie sera réalisé du coupleur inductif de la dalle vers le deuxième coupleur. En revanche, si l'ensemble de fonctionnalisation électrique comporte un ou plusieurs récepteurs (par exemple des diodes lumineuses), le transfert d'énergie se fera dans l'autre sens, c'est-à-dire du deuxième coupleur vers le coupleur de la dalle.

L'agencement du coupleur inductif 220 dans le bloc de transmission d'énergie sans contact 22 définit une surface de couplage SC2 située à l'opposé de la face supérieure F1 de la dalle et avantageusement parallèle à la face inférieure F2.

Le coupleur inductif 220 comporte deux bornes qui sont connectées au convertisseur de tension 210 du bloc électronique 21 évoqué ci-dessus.

Le bloc de transmission d'énergie sans contact 22 peut être réalisé sous la forme d'un élément indépendant fixé sur la dalle 2 ou être intégré au bloc électronique décrit ci-dessus. Le bloc 22 peut notamment comporter un boîtier indépendant enfermant le coupleur inductif 220 ou être logé dans un même boîtier avec le bloc électronique 21.

L'enroulement formant le coupleur inductif 220 pourra être réalisé selon différentes configurations. Il s'agira par exemple d'une bobine de type planaire dont le plan défini par la bobine définit la surface de couplage évoquée ci-dessus. L'enroulement de la bobine planaire est par exemple réalisé par sérigraphie sur un circuit imprimé. L'une des faces du circuit imprimé forme alors la surface de couplage définie ci-dessus.

A partir de dalles réalisées selon cette deuxième configuration, l'infrastructure fonctionnalisée doit disposer de blocs de transmission d'énergie sans contact correspondants pour assurer le transfert d'énergie et ainsi former un système de transmission d'énergie sans contact en deux parties. Un tel système de transmission d'énergie sans contact (autrement dit sans-fil) dans lequel est incluse une ou plusieurs dalles de revêtement 2 du type décrit ci-dessus se compose ainsi de deux parties, une première partie 3 et une deuxième partie, entre lesquelles la transmission d'énergie sans contact est opérée.

La deuxième partie du système est formée de n dalles de revêtement 2 telles que décrites ci-dessus, n étant supérieur ou égal à 1. Dans le cas où le nombre n de dalles est supérieur ou égal à deux, toutes les dalles de revêtement 2 employées dans cette deuxième partie du système pourront être de fonction identique, proposant alors une seule fonctionnalité au système (par exemple des dalles de type photovoltaïque uniquement), ou de fonctions différentes de manière à proposer plusieurs fonctionnalités au système (par exemple un mélange de dalles de type photovoltaïque avec des dalles de signalisation lumineuse).

En référence aux figures 4A et 4B, la première partie 3 du système comporte pour sa part n blocs de transmission d'énergie sans contact 32, n étant supérieur ou égal à 1. Chaque bloc 32 comporte un coupleur inductif 320. Chaque coupleur inductif 320 de cette première partie est destiné à être associé à un coupleur inductif 220 distinct de la deuxième partie. Le coupleur inductif 320 employé dans la première partie comportera avantageusement une architecture similaire à celle du coupleur inductif de la dalle à laquelle il est associé. Il présente ainsi une surface de couplage SC1 destinée à être positionnée en parallèle de la surface de couplage SC2 de la dalle de manière à assurer un transfert d'énergie sans contact. Les caractéristiques de positionnement entre deux enroulements pour obtenir le meilleur rendement possible de transfert d'énergie sans contact sont bien connues dans l'état de la technique et ne sont donc pas décrites dans la présente demande. Cependant, on peut noter que la solution de positionnement retenue sera optimale suivant l'axe x et l'axe y et éventuellement variable dans la troisième dimension (suivant la hauteur définie par l'axe z).

Les documents antérieurs qui concernent notamment des solutions de recharge par induction décrivent de telles caractéristiques.

Pour loger chaque bloc de transmission d'énergie sans contact 32, la première partie 3 comporte avantageusement un ou plusieurs boîtiers. Dans la suite de la description, on considérera que chaque bloc de transmission d'énergie sans contact présente une structure dans laquelle le coupleur inductif 320 est logé dans un premier boîtier 33 qui comporte au moins une paroi définissant une face externe, préférentiellement plane, et une face interne en vis-à-vis de laquelle est positionnée la surface de couplage SC1 du coupleur inductif 320 du bloc. Ce premier boîtier sera avantageusement hermétique et particulièrement résistant pour être employé dans une infrastructure telle que l'une de celles décrites ci-dessus.

Selon la configuration du système, le bloc de transmission d'énergie sans contact 32 pourra comporter un convertisseur statique 310 adapté comprenant deux bornes de connexion entre lesquelles est connecté le coupleur inductif 320. Ce convertisseur statique sera de type AC/DC ou AC/AC, le coupleur inductif étant connecté côté AC. Le bloc comporte avantageusement un deuxième boîtier 34, dans lequel est logé ledit convertisseur statique 310. Ce deuxième boîtier est fixé au premier boîtier. Les deux boîtiers sont par exemple fixés l'un sur l'autre. Le deuxième boîtier s'étend sous le premier boîtier à l'opposé de la surface de couplage. Des moyens de connexion électrique sont prévus pour assurer la connexion électrique entre le coupleur inductif et le convertisseur.

Bien entendu, dans le bloc de transmission d'énergie sans contact 32, tout autre agencement du coupleur inductif et du convertisseur pourrait être envisagé. L'avantage de la mise en œuvre citée ci-dessus repose sur une gestion thermique plus aisée du convertisseur statique dans l'enrobé, car plus éloigné des contraintes thermiques extérieures.

Chaque bloc de transmission d'énergie sans contact 32 de la première partie 3 est connecté électriquement ou inclus dans une architecture électrique. Cette architecture électrique pourra différer, notamment selon les types de dalles 2 employées.

La description ci-dessous vise à expliquer le principe de réalisation d'une infrastructure fonctionnalisée qui intègre un système de transmission d'énergie sans contact tel que décrit ci-dessus.

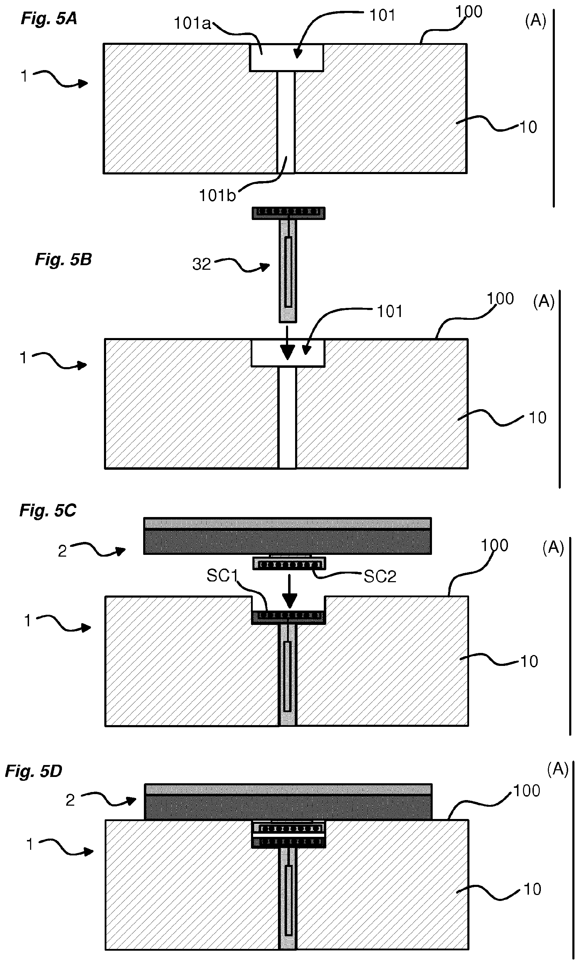

Comme déjà décrit ci-dessus, une infrastructure telle qu'une route comporte par exemple une couche inférieure 10 dotée d'une surface 100 à recouvrir. Selon l'invention, cette surface 100 à recouvrir est destinée à être recouverte, au moins en partie, par les dalles de revêtement 2 de l'invention. Par ailleurs, pour loger la première partie 3 du système, la solution de l'invention consiste à réaliser n cavités 101 ou trous dans la couche inférieure 10 de l'infrastructure, n étant supérieur ou égal à 1 (figure 5A). Chaque cavité est destinée à recevoir un bloc de transmission d'énergie sans contact 32 de la première partie du système, chaque bloc 32 étant positionné dans la cavité de manière à orienter la surface de couplage SC1 de son coupleur inductif 320 vers le haut (figure 5B).

De manière avantageuse, chaque cavité 101 est toujours réalisée avec des dimensions standards, c'est-à-dire profondeur, section à l'ouverture, forme de ladite section.

L'ouverture de la cavité 101 est ensuite recouverte par une dalle 2 (figures 5C et 5D). Des moyens mécaniques de positionnement et de centrage sont préférentiellement agencés pour permettre un positionnement et centrage parfait de la dalle 2 par rapport à la cavité 101. Il s'agira par exemple de réaliser le boîtier de la dalle qui enferme le coupleur inductif avec des dimensions adaptées pour que celui-ci coopère, avec un jeu minimal, avec le bord de l'ouverture supérieure de la cavité.

La profondeur de chaque cavité est adaptée pour que la surface de couplage SC1 du bloc 32 soit située à une hauteur suffisante pour favoriser la transmission d'énergie entre les deux coupleurs 220, 320.

Autrement dit, il faut que les deux coupleurs 220, 320 soient disposés bien en face l'un de l'autre suivant les axes x et y et respecter un espace entre eux suivant l'axe z qui soit adapté pour garantir un rendement de couplage satisfaisant.

En référence à la figure 5A, chaque cavité 101 présente par exemple une forme définissant une partie supérieure 101a de section constante, prolongée d'une partie inférieure 101b rétrécie par rapport à la partie supérieure et également de section constante. La partie inférieure de la cavité est destinée à recevoir le deuxième boîtier 34 du bloc de transmission d'énergie sans contact et la partie supérieure est destinée à recevoir le premier boîtier 33 du bloc de transmission d'énergie sans contact.

Lorsque le système comporte une première partie à n blocs de transmission d'énergie et donc n coupleurs inductifs, avec n supérieur ou égal à 2, l'infrastructure est dotée de n cavités du type de celle décrite ci-dessus de manière à accueillir chacune un bloc de transmission d'énergie sans contact 32 distinct.

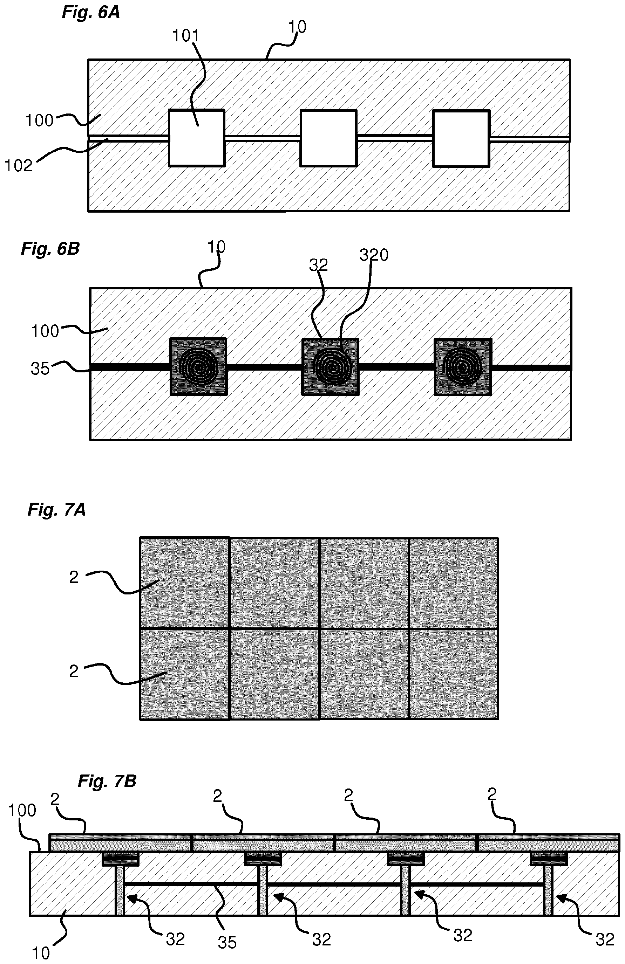

Selon l'invention, en référence aux figures 6A et 6B, l'infrastructure comporte une tranchée 102 réalisée dans la couche inférieure 10 et reliant chaque cavité 101 à une cavité adjacente.

Selon l'invention, dans le système, chaque bloc de transmission d'énergie sans contact 32 de la première partie est ainsi connecté au bloc adjacent par au moins un câble de liaison 35, formant une forme de bus selon l'une des architectures électriques présentées ci-dessus. Et chaque câble de liaison 35 s'étend dans une tranchée 102 reliant deux cavités (figure 6B). Le câble pourra prendre toute forme adaptée et sera connecté d'un bloc à l'autre. Il pourra s'agit par exemple d'une nappe de fils flexible.

Grâce à l'architecture du système et à celle de l'infrastructure, la réalisation d'une infrastructure fonctionnalisée est simple. Il s'agit en effet de mettre en œuvre les étapes suivantes :
- Creuser plusieurs cavités 101 et plusieurs tranchées, une tranchée reliant une cavité à une cavité adjacente. Chaque cavité 101 prend par exemple la forme décrite ci-dessus à deux volumes superposées distincts de manière à former un rétrécissement.
- Positionner la première partie 3 du système de de sorte que chaque bloc de transmission d'énergie sans contact 32 soit positionné dans une cavité distincte. La surface de couplage SC1 du bloc est positionnée vers le haut.
- Positionner une dalle de revêtement au-dessus de chaque cavité 101, de manière à recouvrir au moins partiellement la surface 100 de la couche inférieure 10, la surface de couplage SC2 de la dalle étant positionnée parallèlement à la surface SC1 et à une distance imposée par le positionnement mécanique de la dalle, cette distance étant adaptée pour permettre une transmission d'énergie sans contact avec le meilleur rendement possible.

La figure 7A montre ainsi une surface entièrement recouverte de dalles 2 selon l'invention. La figure 7B montre pour sa part les dalles positionnées de manière adjacente sur la surface 100 de la couche inférieure 10. Les surfaces externes des n dalles positionnées de manière juxtaposée sont agencées dans un même plan, formant le plan de la chaussée. Les n dalles posées sur la couche inférieure sont donc ajustées les unes par rapport aux autres, notamment en termes de dimensions, pour être parfaitement jointives et paver ainsi au maximum la surface à recouvrir de la couche inférieure.

L'un des intérêts de réaliser une infrastructure fonctionnalisée qui utilise des dalles de revêtements telles que décrites ci-dessus est de pouvoir proposer des dalles de forme standard, permettant notamment une installation rapide. Cependant, une standardisation de la forme des dalles présente une difficulté quant à la possibilité de recouvrir exactement toute une surface avec des dalles juxtaposées et jointives puisque cette surface à recouvrir peut présenter un contour ayant des portions courbes.

Par ailleurs, quelle que soit la configuration employée, c'est-à-dire à base de dalles reliées directement entre elles par câblage ou utilisant une solution de transmission d'énergie sans contact telle que décrite ci-dessus, il est avantageux d'employer des câbles de liaison électrique qui soient globalement tous d'une longueur identique. Autrement dit, il est important que le bloc de connexion électrique d'une dalle soit séparé du bloc de connexion électrique de chaque dalle adjacente d'une distance rectiligne identique, afin d'assurer un pas constant et de permettre une reproductibilité d'un motif de connexion électrique d'une dalle à l'autre.

Partant de ces différentes contraintes, l'invention vise à proposer une infrastructure fonctionnalisée dans laquelle :
- Les dalles sont d'au moins deux formes distinctes tout en présentant la même architecture fonctionnelle décrite ci-dessus en liaison avec les figures ;
- Chaque dalle est configurée de manière à ce que son bloc de connexion électrique 23 soit séparé du bloc de connexion électrique d'une dalle adjacente d'une distance toujours identique (suivant un trajet rectiligne), c'est-à-dire d'un pas constant ;

On peut imaginer que les n dalles juxtaposées sont chacune d'un rang i, avec i allant de 1 à n. Par rapport à la dalle de rang i-1 et à la dalle de rang i+1, la dalle de rang i est séparée du pas constant P, ledit pas constant P pouvant correspondre par exemple à une longueur du câble tiré suivant une direction rectiligne entre les deux blocs de connexion de deux dalles juxtaposées.

Ainsi, dans le cas d'un système à transmission d'énergie sans contact, la position du bloc de connexion électrique sur la dalle permet de fixer la position du coupleur inductif et ainsi d'assurer que celui-ci est toujours positionné en vis-à-vis du coupleur inductif de la première partie du système.

Par forme de la dalle, on entend le contour de sa face supérieure F1 déterminant ainsi la surface externe de la dalle et donc celle qui vient recouvrir une partie de la surface de la couche inférieure.

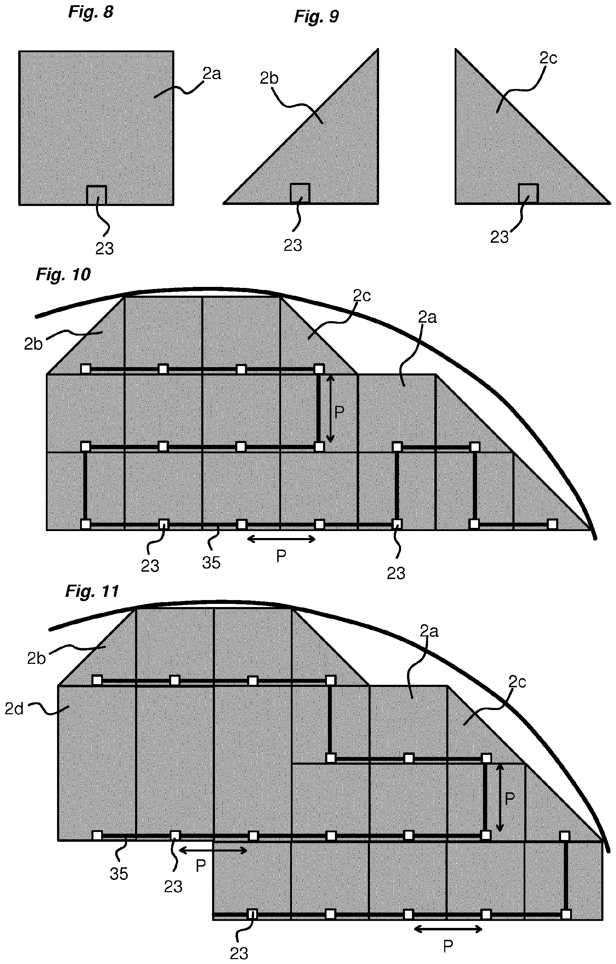

De manière avantageuse mais non limitative, en référence aux figures 8 et 9, on aura ainsi un premier type de dalle de revêtement ayant une forme carrée (référence 2a sur les figures) et un deuxième type de dalle de revêtement qui présente une forme en triangle (références 2b et 2c sur les figures, selon l'orientation du triangle). La dalle de deuxième type est plus particulièrement en forme de triangle rectangle isocèle. Dans cette dalle, les deux petits côtés sont d'une longueur égale à celle de chaque côté du carré formé par la dalle en forme de carré. On comprend ainsi que la dalle de deuxième type définit une surface égale à la moitié de celle définie par la dalle de premier type.

Selon l'invention, le bloc de connexion électrique 23 déjà décrit ci-dessus est inclus dans la dalle de manière à assurer un pas constant d'une dalle à l'autre quelle que soit la forme de la dalle. Pour la dalle de type carré, le bloc de connexion électrique 23 est avantageusement positionné sous la dalle, sur la surface inférieure F2 de la dalle, à l'aplomb du milieu de l'un des côtés de la dalle. Pour la dalle de type triangle, le bloc de connexion électrique 23 est avantageusement positionné sous la dalle, à l'aplomb du milieu d'un des petits côtés du triangle formé par la dalle. Pour la dalle en forme de triangle, comme représenté sur la figure 8, le bloc de connexion électrique 23 pourra être positionné suivant l'un ou l'autre des petits côtés du triangle (configuration de dalle 2b ou 2c sur la figure 8).

Les figures 8 à 11 montrent par transparence la position du bloc de connexion électrique sous la dalle.

La figure 10 illustre le principe de mise en œuvre d'un pas constant P entre des dalles des deux formes précitées pour réaliser une infrastructure fonctionnalisée présentant une portion courbe. Sur cette figure 11, l'infrastructure est formée par la juxtaposition de plusieurs dalles de forme carrée 2a et de dalles en triangle 2b ou 2c, afin de recouvrir au mieux et au maximum la surface 100 à recouvrir de la couche inférieure 10. Il faut comprendre que l'infrastructure pourra être réalisée en connectant directement les dalles selon la configuration présentée sur la figure 3A ou par l'intermédiaire de la solution sans contact selon la configuration représentée sur la figure 3B. On remarque sur cette figure que la position du bloc de connexion électrique 23 permet de conserver le pas P constant d'une dalle à l'autre et dans deux directions perpendiculaires, dans le plan de pavage de la zone.

La figure 11 représente une variante de réalisation employant également des dalles 2d de forme rectangulaire. Le rectangle formé par la dalle représenterait deux surfaces carrées juxtaposées telles que décrites ci-dessus. De même, le pas P constant est maintenu entre les dalles suivant les deux directions perpendiculaires. On pourra considérer que le pas constant doit au moins être maintenu dans une première direction, notamment lorsque les dalles sont alignées de manière juxtaposées suivant cette première direction. Par le terme "juxtaposé", on veut dire que les dalles sont jointives par un de leurs côtés, les deux côtés jointifs étant de longueurs égales.

De la figure 11, on comprend également qu'il est possible de réaliser, dans une même infrastructure fonctionnalisée, plusieurs séries de dalles connectées entre elles par un pas P constant de l'une à l'autre. Cela est illustré par la figure 11 sur laquelle on peut voir une première série de dalles connectées entre elles et une deuxième série de dalles connectées entre elles. Répartir les dalles en plusieurs séries permet notamment de conserver toujours le pas constant d'une dalle à l'autre quelle que soit la forme de la dalle.

L'invention présente ainsi un certain nombre d'avantages, parmi lesquelles :
- Une facilité de réalisation d'une infrastructure fonctionnalisée, par le simple positionnement de dalles fonctionnalisées.
- Une possibilité de configurer l'infrastructure en mixant plusieurs types de dalles, tout en conservant un même mode d'installation.
- Une infrastructure facile à entretenir, grâce notamment à la possibilité de remplacer une dalle défaillante aisément, sans avoir à toucher à toute l'infrastructure.
- Une standardisation de l'infrastructure, en employant des dalles ayant des formes standards et connectées entre elles par des liaisons électriques de longueur toujours identiques grâce à l'obtention d'un pas constant.

## Revendications

1. Infrastructure fonctionnalisée comportant une couche inférieure (10) comprenant une zone (100) à recouvrir, ladite infrastructure comportant :
- n dalles de revêtement (2), n étant supérieur ou égal 2, les n dalles comportant chacune une surface de couverture pour recouvrir une partie de ladite zone (100), les n dalles étant agencées de manière juxtaposée afin de paver ladite surface à recouvrir, chaque dalle de revêtement comprenant au moins un ensemble de fonctionnalisation électrique (20);
- Les n dalles de revêtement comportent au moins une dalle de revêtement (2a) d'un premier type présentant une surface de couverture d'une première forme et une dalle de revêtement (2b, 2c) d'un deuxième type présentant une surface de couverture d'une deuxième forme, distincte de la première forme;
ladite infrastructure étant **caractérisée en ce que**:
- Chaque dalle de revêtement comporte un bloc de connexion électrique (23), de telle sorte que pour deux dalles adjacentes directement connectées entres elles:
- Le bloc de connexion électrique (23) de chaque dalle est agencé sur la dalle de manière à être séparé du bloc de connexion électrique de la dalle adjacente d'un pas (P) constant, quelle que soit la forme de chacune de leur dalle,
- L'infrastructure comporte un câble électrique de liaison (35) entre lesdites deux dalles adjacentes, ledit câble étant d'une longueur correspondant audit pas constant.

2. Infrastructure selon la revendication 1, **caractérisée en ce que** ledit bloc de connexion électrique (23) est agencé sur chaque dalle de rang i manière à générer un pas (P) constant suivant deux directions perpendiculaires.

3. Infrastructure selon la revendication 1 ou 2, **caractérisée en ce que** ladite dalle (2a) de premier type présente une surface de couverture de forme carrée.

4. Infrastructure selon la revendication 3, **caractérisée en ce que** le bloc de connexion électrique (23) est positionné suivant l'un des côtés du carré formé par la surface de couverture.

5. Infrastructure selon la revendication 3, **caractérisée en ce que** ladite dalle (2b, 2c) de deuxième type présente une surface de couverture ayant une forme de triangle rectangle isocèle, dont chaque petit côté présente une longueur égale à celle d'un côté du carré formé par la surface de couverture de la dalle de premier type.

6. Infrastructure selon la revendication 5, **caractérisée en ce que** le bloc de connexion électrique (23) est agencé suivant l'un ou l'autre des deux petits côtés du triangle rectangle isocèle formé par la surface de recouvrement de la dalle de deuxième type.

7. Infrastructure selon l'une des revendications 1 à 6, **caractérisé en ce que** le câble de liaison (35) est agencé pour relier le bloc de connexion électrique (23) de chaque dalle au bloc de connexion électrique de la dalle adjacente.

8. Infrastructure selon l'une des revendications 1 à 6, **caractérisée en ce que** chaque dalle comporte un bloc (22) de transmission d'énergie sans contact connecté sur ledit bloc de connexion électrique (23).

9. Infrastructure selon la revendication 8, **caractérisée en ce qu'**elle comporte un système de transmission d'énergie sans contact comprenant une première partie présentant n blocs (32) de transmission d'énergie sans contact et une deuxième partie formée desdites n dalles, chaque bloc (32) de transmission d'énergie sans contact de la première partie étant positionné pour être en couplage inductif avec un bloc (22) de transmission d'énergie sans contact correspondant distinct de la première partie.

10. Infrastructure selon la revendication 9, **caractérisée en ce que** le câble de liaison (35) est agencé pour relier chaque bloc (32) de transmission d'énergie sans contact de la première partie d'un bloc de transmission d'énergie sans contact adjacent de la première partie..

11. Infrastructure selon l'une des revendications 1 à 10, **caractérisé en ce que** chaque dalle comporte un ensemble de fonctionnalisation électrique de type générateur d'énergie électrique ou de type récepteur d'énergie électrique.

12. Procédé d'installation d'une infrastructure fonctionnalisée comportant une couche inférieure (10) comprenant une zone (100) à recouvrir, ledit procédé consistant à:
- Recouvrir ladite zone (100) avec n dalles de revêtement (2) agencées de manière juxtaposée afin de paver ladite surface à recouvrir, chaque dalle de revêtement comprenant une surface de couverture positionnée pour recouvrir une partie de ladite zone et au moins un ensemble de fonctionnalisation électrique (20);
- Les n dalles de revêtement comportent au moins une dalle de revêtement (2a) d'un premier type présentant une surface de couverture d'une première forme et une dalle de revêtement (2b, 2c) d'un deuxième type présentant une surface de couverture d'une deuxième forme, distincte de la première forme;
ledit procédé étant **caractérisé en ce que**:
- Chaque dalle de revêtement comporte un bloc de connexion électrique (23), de telle sorte que pour deux dalles adjacentes directement connectées entres elles:
- Le bloc de connexion électrique de chaque dalle est agencé sur la dalle de manière à être séparé du bloc de connexion électrique de la dalle adjacente d'un pas (P) constant, quelle que soit la forme de chacune de leur dalle, un câble électrique de liaison (35) de longueur correspondant audit pas constant étant agencé pour relier lesdites deux dalles adjacentes.

13. Procédé selon la revendication 12, **caractérisée en ce que** ladite dalle de revêtement (2a) de premier type présente une surface de couverture de forme carrée.

14. Procédé selon la revendication 12 ou 13, **caractérisée en ce que** ladite dalle de revêtement (2b, 2c) de deuxième type présente une surface de couverture ayant une forme de triangle rectangle isocèle, dont chaque petit côté présente une longueur égale à celle d'un côté du carré formé par la surface de couverture de la dalle de premier type.

15. Procédé selon l'une des revendications 12 à 14, **caractérisé en ce que** le câble de liaison (35) est agencé pour relier le bloc de connexion électrique (23) de chaque dalle au bloc de connexion électrique de la dalle adjacente.

16. Procédé selon l'une des revendications 12 à 14, **caractérisé en ce qu'**il consiste à mettre en œuvre un système de transmission d'énergie sans contact entre une première partie présentant n blocs (32) de transmission d'énergie sans contact et une deuxième partie formée desdites n dalles de revêtement, chaque bloc (32) de transmission d'énergie sans contact de la première partie étant positionné pour être en couplage inductif avec un bloc (22) de transmission d'énergie sans contact correspondant distinct de la première partie et **en ce que** le câble de liaison (35) est agencé pour relier chaque bloc de transmission d'énergie sans contact de la première partie d'un bloc de transmission d'énergie sans contact adjacent de la première partie.

## Patentansprüche

1. Funktionalisierte Infrastruktur mit einer unteren Schicht (10), die eine zu bedeckende Zone (100) aufweist, wobei die Infrastruktur
- n Abdeckplatten (2) aufweist, wobei n größer als oder gleich 2 ist, wobei jede der n Platten eine Abdeckoberfläche aufweist, um einen Teil der Zone (100) zu bedecken, wobei die n Platten aneinander angrenzend angeordnet sind, um die zu bedeckende Fläche zu bedecken, wobei jede Abdeckplatte wenigstens eine Gruppe zur elektrischen Funktionalisierung (20) aufweist,
- wobei die n Abdeckplatten wenigstens eine Abdeckplatte (2a) eines ersten Typs, die eine Abdeckoberfläche einer ersten Form aufweist, und eine Abdeckplatte (2b, 2c) eines zweiten Typs, die eine von der ersten Form verschiedene zweite Form aufweist, aufweisen,
wobei die Infrastruktur **dadurch gekennzeichnet ist, daß**
- jede Abdeckplatte einen Block (23) für eine elektrische Verbindung derart aufweist, daß für zwei aneinander angrenzende, direkt miteinander verbundene Platten
- der Block (23) für eine elektrische Verbindung jeder Platte auf der Platte so angeordnet ist, daß er vom Block für eine elektrische Verbindung der angrenzenden Platte unabhängig von der Form jeder Platte mit einem konstanten Abstand (P) getrennt ist,
- die Infrastruktur ein elektrisches Verbindungskabel (35) zwischen den beiden aneinander angrenzenden Platten aufweist, wobei das Kabel eine dem konstanten Abstand entsprechende Länge hat.

2. Infrastruktur gemäß Anspruch 1, **dadurch gekennzeichnet, daß** der Block (23) für eine elektrische Verbindung auf jeder Platte des Rangs i so angeordnet ist, daß ein konstanter Abstand (P) in zwei zueinander senkrechten Richtungen erzeugt wird.

3. Infrastruktur gemäß Anspruch 1 oder 2, **dadurch gekennzeichnet, daß** die Platte (2a) vom ersten Typ eine quadratische Abdeckoberfläche aufweist.

4. Infrastruktur gemäß Anspruch 3, **dadurch gekennzeichnet, daß** der Block (23) für eine elektrische Verbindung an einer der Seiten des durch die Abdeckoberfläche gebildeten Quadrats positioniert ist.

5. Infrastruktur gemäß Anspruch 3, **dadurch gekennzeichnet, daß** die Abdeckplatte (2b, 2c) vom zweiten Typ eine Abdeckoberfläche mit der Form eines rechtwinkligen gleichschenkligen Dreiecks aufweist, bei dem jede kurze Seite eine Länge aufweist, die gleich jener einer Seite des durch die Abdeckoberfläche der Platte des ersten Typs gebildeten Quadrats ist.

6. Infrastruktur gemäß Anspruch 5, **dadurch gekennzeichnet, daß** der Block (23) für eine elektrische Verbindung an der einen oder der anderen der beiden kurzen Seiten des durch die Abdeckoberfläche der Platte des zweiten Typs gebildeten rechtwinkligen gleichschenkligen Dreiecks angeordnet ist.

7. Infrastruktur gemäß einem der Ansprüche 1 bis 6, **dadurch gekennzeichnet, daß** das Verbindungskabel (35) dazu ausgeführt ist, den Block (23) für eine elektrische Verbindung jeder Platte mit dem Block für eine elektrische Verbindung der angrenzenden Platte zu verbinden.

8. Infrastruktur gemäß einem der Ansprüche 1 bis 6, **dadurch gekennzeichnet, daß** jede Platte einen mit dem Block (23) für eine elektrische Verbindung verbundenen Block (22) für eine kontaktlose Energieübertragung aufweist.

9. Infrastruktur gemäß Anspruch 8, **dadurch gekennzeichnet, daß** sie ein System für eine kontaktlose Energieübertragung aufweist, das einen n Blöcke (32) für eine kontaktlose Energieübertragung aufweisenden ersten Teil und einen von den n Platten gebildeten zweiten Teil aufweist, wobei jeder Block (32) für eine kontaktlose Energieübertragung des ersten Teils so positioniert ist, daß er mit einem gesonderten entsprechenden Block (22) für eine kontaktlose Energieübertragung des ersten Teils induktiv gekoppelt ist.

10. Infrastruktur gemäß Anspruch 9, **dadurch gekennzeichnet, daß** das Verbindungskabel (35) dazu ausgelegt ist, jeden Block (32) für eine kontaktlose Energieübertragung des ersten Teils mit einem angrenzenden Block für eine kontaktlose Energieübertragung des ersten Teils zu verbinden.

11. Infrastruktur gemäß einem der Ansprüche 1 bis 10, **dadurch gekennzeichnet, daß** jede Platte eine Gruppe zur elektrischen Funktionalisierung vom Typ eines Generators elektrischer Energie oder vom Typ eines Empfängers elektrischer Energie aufweist.

12. Verfahren zum Installieren einer funktionalisierten Infrastruktur, die eine eine zu bedeckende Zone (100) aufweisende untere Schicht (10) aufweist, wobei das Verfahren darin besteht,
- die Zone (100) mit n Abdeckplatten (2) zu bedecken, die aneinander angrenzend angeordnet sind, um die zu bedeckende Oberfläche zu bedecken, wobei jede Abdeckplatte eine Abdeckoberfläche, die so angeordnet ist, daß sie einen Teil der Zone bedeckt, und wenigstens eine Gruppe zur elektrischen Funktionalisierung (20) aufweist,
- wobei die n Abdeckplatten wenigstens eine Abdeckplatte (2a) eines ersten Typs, die eine Abdeckoberfläche einer ersten Form aufweist, und eine Abdeckplatte (2b, 2c) eines zweiten Typs, die eine von der ersten Form verschiedene zweite Form aufweist, aufweisen,
wobei das Verfahren **dadurch gekennzeichnet ist, daß**
- jede Abdeckplatte einen Block (23) für eine elektrische Verbindung derart aufweist, daß für zwei aneinander angrenzende, direkt miteinander verbundene Platten
- der Block für eine elektrische Verbindung jeder Platte auf der Platte so angeordnet ist, daß er vom Block für eine elektrische Verbindung der angrenzenden Platte unabhängig von der Form jeder Platte mit einem konstanten Abstand (P) getrennt ist, wobei ein elektrisches Verbindungskabel (35) mit einer dem konstanten Abstand entsprechende Länge dazu ausgelegt ist, die beiden aneinander angrenzenden Platten zu verbinden.

13. Verfahren gemäß Anspruch 12, **dadurch gekennzeichnet, daß** die Abdeckplatte (2a) vom ersten Typ eine Abdeckoberfläche von quadratischer Form aufweist.

14. Verfahren gemäß Anspruch 12 oder 13, **dadurch gekennzeichnet, daß** die Abdeckplatte (2b, 2c) vom zweiten Typ eine Abdeckoberfläche mit der Form eines rechtwinkligen gleichschenkligen Dreiecks aufweist, bei dem jede kurze Seite eine Länge aufweist, die gleich jener einer Seite des durch die Abdeckoberfläche der Platte des ersten Typs gebildeten Quadrats ist.

15. Verfahren gemäß einem der Ansprüche 12 bis 14, **dadurch gekennzeichnet, daß** das Verbindungskabel (35) dazu ausgeführt ist, den Block (23) für eine elektrische Verbindung jeder Platte mit dem Block für eine elektrische Verbindung der angrenzenden Platte zu verbinden.

16. Verfahren gemäß einem der Ansprüche 12 bis 14, **dadurch gekennzeichnet, daß** es darin besteht, ein System für eine kontaktlose Energieübertragung zwischen einem n Blöcke (32) für eine kontaktlose Energieübertragung aufweisenden ersten Teil und einem von den n Platten gebildeten zweiten Teil einzurichten, wobei jeder Block (32) für eine kontaktlose Energieübertragung des ersten Teils so positioniert ist, daß er mit einem gesonderten entsprechenden Block (22) für eine kontaktlose Energieübertragung des ersten Teils induktiv gekoppelt ist, und daß das Verbindungskabel (35) dazu ausgelegt ist, jeden Block für eine kontaktlose Energieübertragung des ersten Teils mit einem angrenzenden Block für eine kontaktlose Energieübertragung des ersten Teils zu verbinden.

## Claims

1. Functionalized infrastructure comprising a bottom layer (10) comprising a zone (100) to be covered, said infrastructure comprising:
- n covering slabs (2), n being greater than or equal to 2, the n slabs each comprising a coverage surface for covering a part of said zone (100), the n slabs being arranged juxtaposed in order to pave said surface to be covered, each covering slab comprising at least one electrical functionalization assembly,
- the n covering slabs comprise at least one covering slab (2a) of a first type having a coverage surface of a first form and a covering slab (2b, 2c) of a second type having a coverage surface of a second form, distinct from the first form,
said infrastructure being **characterized in that**:
- each covering slab comprises an electrical connection block (23), such that, for two adjacent slabs directly connected with each other:
- the electrical connection block (23) of each slab is arranged on the slab so as to be separated from the electrical connection block of the adjacent slab by a pitch (P) that is constant, whatever the form of each of their slabs,
- the infrastructure comprises an electrical connecting cable (35) between said two adjacent slabs, said cable being of a length corresponding to said constant pitch.

2. Infrastructure according to Claim 1, **characterized in that** said electrical connection block (23) is arranged on each slab of rank so as to generate a pitch (P) that is constant in two right-angled directions.

3. Infrastructure according to Claim 1 or 2, **characterized in that** said slab (2a) of the first type has a coverage surface of square form.

4. Infrastructure according to Claim 3, **characterized in that** the electrical connection block (23) is positioned along one of the sides of the square formed by the coverage surface.

5. Infrastructure according to Claim 3, **characterized in that** said slab (2b, 2c) of second type has a coverage surface having an isosceles right-angled triangle form, of which each small side has a length equal to that of a side of the square formed by the coverage surface of the slab of first type.

6. Infrastructure according to Claim 5, **characterized in that** the electrical connection block (23) is arranged along one or other of the two small sides of the isosceles right-angled triangle formed by the coverage surface of the slab of second type.

7. Infrastructure according to one of Claims 1 to 6, **characterized in that** the connecting cable (35) is arranged to connect the electrical connection block (23) of each slab to the electrical connection block of the adjacent slab.

8. Infrastructure according to one of Claims 1 to 6, **characterized in that** each slab comprises a contactless energy transmission block (22) connected to said electrical connection block (23).

9. Infrastructure according to Claim 8, **characterized in that** it comprises a contactless energy transmission system comprising a first part having n contactless energy transmission blocks (32) and a second part formed by said n slabs, each contactless energy transmission block (32) of the first part being positioned to be inductively coupled with a distinct corresponding contactless energy transmission block (22) of the first part.

10. Infrastructure according to Claim 9, **characterized in that** the connecting cable (35) is arranged to connect each contactless energy transmission block (32) of the first part to an adjacent contactless energy transmission block of the first part.

11. Infrastructure according to one of Claims 1 to 10, **characterized in that** each slab comprises an electrical functionalization assembly of the electrical energy generator type or of the electrical energy receiver type.

12. Method for installing a functionalized infrastructure comprising a bottom layer (10) comprising a zone (100) to be covered, said method consisting in:
- covering said zone (100) with n covering slabs (2) arranged juxtaposed in order to pave said surface to be covered, each covering slab comprising a coverage surface positioned to cover a part of said zone and at least one electrical functionalization assembly (20),
- the n covering slabs comprise at least one covering slab (2a) of a first type having a coverage surface of a first form and a covering slab (2b, 2c) of a second type having a coverage surface of a second form, distinct from the first form,
said method being **characterized in that**:
- each covering slab comprises an electrical connection block (23), such that, for two adjacent slabs directly connected with each other:
- the electrical connection block of each slab is arranged on the slab so as to be separated from the electrical connection block of the adjacent slab by a pitch (P) that is constant, whatever the form of each of their slabs, an electrical connecting cable (35) of a length corresponding to said constant pitch being arranged to connect said two adjacent slabs.

13. Method according to Claim 12, **characterized in that** said covering slab (2a) of first type has a coverage surface of square form.

14. Method according to Claim 12 or 13, **characterized in that** said covering slab (2b, 2c) of second type has a coverage surface having an isosceles right-angled triangle form, of which each small side has a length equal to that of a side of the square formed by the coverage surface of the slab of first type.

15. Method according to one of Claims 12 to 14, **characterized in that** the connecting cable (35) is arranged to connect the electrical connection block (23) of each slab to the electrical connection block of the adjacent slab.

16. Method according to one of Claims 12 to 14, **characterized in that** it consists in implementing a contactless energy transmission system between a first part having n contactless energy transmission blocks (32) and a second part formed by said n covering slabs, each contactless energy transmission block (32) of the first part being positioned to be inductively coupled with a distinct corresponding contactless energy transmission block (22) of the first part and **in that** the connecting cable (35) is arranged to connect each contactless energy transmission block of the first part to an adjacent contactless energy transmission block of the first part.
